# EUROPEAN PATENT SPECIFICATION

(11) **EP 0 592 076 B1**
(45) Date of publication and mention of the grant of the patent: **09.08.2000**
(21) Application number: 93305709.3
(22) Date of filing: 20.07.1993
(51) Int. Cl.: G06F 17/50

(54) **Compilation mechanism for a simulation model**
Kompilierungsmechanismus für ein Simulationsmodell
Mécanisme de compilation pour un modèle de simulation

(30) Priority: 23.09.1992 GB 9220085
(43) Date of publication of application: 13.04.1994
(73) Proprietor: INTERNATIONAL COMPUTERS LIMITED, Putney, London, SW15 1SW (GB)
(72) Inventor: Harris, Duncan James Alexander, Hyde, Cheshire SK14 4Se (GB); Shaar, Zakwan, Stockport SK4 2DG (GB); Hodgson, Steven, Manchester M32 2SP (GB)
(74) Representative: Guyatt, Derek Charles

(56) References cited:
- IEEE INTERNATIONAL CONFERENCE ON COMPUTER-AIDED DESIGN, 5 November 1989, SANTA CLARA CA US pages 176 - 179 ACOSTA ET AL 'mixed-mode simulation of compiled vhdl programs'
- IEEE INTERNATIONAL CONFERENCE ON COMPUTER DESIGN : VLSI IN COMPUTERS & PROCESSORS, 2 October 1989, CAMBRIDGE MASS US pages 542 - 547 ABRAMOVICI ET AL 'system-level design verification in the at&t computer division : overview and strategy'
- IEEE INTERNATIONAL CONFERENCE ON COMPUTER DESIGN : VLSI IN COMPUTERS & PROCESSORS, 2 October 1989, CAMBRIDGE MASS US pages 548 - 554 ABRAMOVICI ET AL 'system-level desgn verification in the at&t computer division : tools'
- EUROPEAN CONFERENCE ON ELECTRONIC DESIGN AUTOMATION, 26 March 1984, WARWICK GB pages 107 - 110 HODGSON 'a multilevel, mixed state simulator for hierarchical design verification'

## Description

### Background to the Invention

This invention relates to a compilation mechanism for generating a simulation model of a logic system.

Simulation models are widely used as design aids in the design and development of complex logic systems, such as computer systems. Such simulation models are generally implemented by means of software, running on general-purpose computer hardware. However, in principle, they could alternatively be implemented using special purpose hardware techniques.

The design of a logic system may be represented by a number of design units, connected together in a network in a specified manner. Each of these units may be represented by a behaviour specification, ie a set of rules or algorithms that specify the behaviour of the unit. Alternatively, a design unit may be represented by a sub-network of lower-level design units, each of which in turn may be represented either by a behaviour specification or a sub-network. In other words, the design can be specified as a hierarchical network.

As the design of such a system is developed, it will be necessary to modify the way in which the design units are represented. In particular, a sub-network for a design unit may be replaced by a behaviour. It is then necessary to check the sub-network and the behaviour for equivalence.

Once equivalence has been established, the behaviour can replace the sub-network in all subsequent simulation. This reduces the size of the simulation model considerably, and reduces simulation run times.

This is easy to do if test data has been fully developed for the design unit. However, it is often the case that the unit is part of a higher-level network and test data exists only for this higher-level network. In order to generate test data for such a design unit, it has hitherto been necessary to run a simulation model of the higher-level network and to extract test patterns for the unit in question from the simulation model. However, this pattern extraction has been found to be very expensive in terms of machine time, since test pattern sequences are generally very long.

The object of the present invention is to provide a way of avoiding the need for such pattern extraction.

### Summary of the Invention

According to the invention there is provided a compilation mechanism for generating a simulation model of a logic system comprising a plurality of design units connected together in a network, wherein the compilation mechanism is selectively operable to expand a selected one of said design units as both a sub-network and a behaviour, arranged within the model such that they will execute during simulation in parallel. This is referred to herein as concurrent compilation.

At simulation time, a further provision of the invention allows a concurrently compiled design unit to be automatically checked for equivalence between the aforementioned sub-network and behaviour. This is referred to herein as concurrent comparison.

### Brief Description of the Drawings

Figure 1 is a data flow diagram of a compilation mechanism for generating a simulation model.
Figure 2 is a flow chart showing the operation of the compilation mechanism.
Figure 3 is a flow chart showing the operation of a CHECK command.
Figure 4 is a schematic diagram representing an example of the contents of a design database.
Figure 5 is a schematic diagram representing an example of a simulation model generated by the compilation mechanism.

### Description of an Embodiment of the Invention

One compilation mechanism in accordance with the present invention will now be described by way of example with reference to the accompanying drawings.

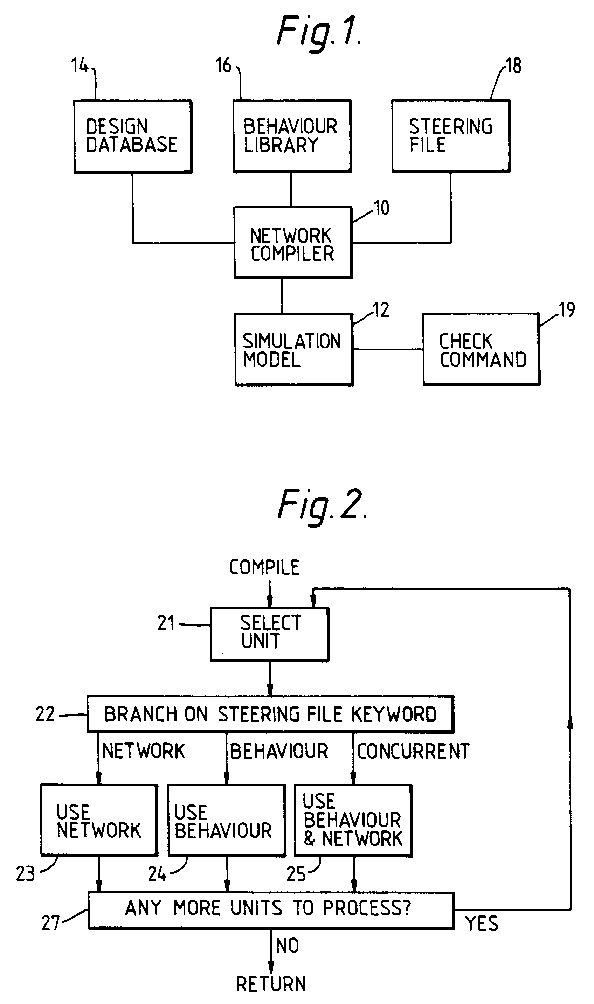

Referring to Figure 1, the compilation mechanism includes a network compiler 10 which generates a simulation model 12. The compiler makes use of a design database 14, a behaviour library 16 and a compiler steering file 18.

The design database 14 consists of a collection of data objects, each having a unique name. These objects include a plurality of network objects, each of which defines a design unit in terms of a sub-network.

The behaviour library 16 consists of a collection of compiled behaviour specifications, each of which specifies the behaviour of a design unit in terms of a set of rules or algorithms.

The compiler steering file 18 comprises a set of statements of the form:
(keyword, name)

Where "name" is the name of a particular design unit, and "keyword" is one of the following options.
Network - expand the design unit in terms of a sub-network.
Behaviour - simulate the design unit by means of a behavioural simulation, ie in terms of its behaviour specification.
Concurrent - simulate the design unit in terms of its behaviour specification and also expand the unit as a sub-network, in parallel with the behavioural simulation.

A CHECK command 19 is also provided, for checking that the outputs of concurrently compiled behaviour and sub-network are the same, as will be described.

Referring now to Figure 2, this shows the operation of the compiler 10 in response to a COMPILE command, specifying that a simulation model is to be generated for a particular top-level design unit.
(21) The compiler first selects a design unit for processing. Initially, this is the top-level design unit.
(22) The compiler then examines the steering file 18 to find a statement relating to the selected design unit. The compiler branches according to the keyword in the statement.
(23) If the keyword is "Network", the compiler expands the selected design unit, by replacing it with a sub-network, obtained from the design database 14. All the design units in the sub-network then become available for processing.
(24) If the keyword is "Behaviour", the compiler fetches the behaviour specification for the design unit from the behaviour library 16 and records a reference to it in the simulation model. This specification contains the simulation code necessary for simulating the behaviour.
(25) If the keyword is "Concurrent", the compiler performs the actions specified above for "Network" and "Behaviour", so that the compiled simulation model will contain both the behavioural representation and the sub-network expansion of the design unit in parallel.
(27) If there are now no more design units for processing, the compilation is complete. Otherwise, the compiler returns to step 21 above, to select the next design unit for processing.

When the simulation model has been generated, it can be run, using suitable input test data sequences. Where the simulation model contains concurrent representations of a design unit in terms of its behaviour and its network expansion, the results of these two representations can be compared, to check for equivalence, using the CHECK command, as will now be described.

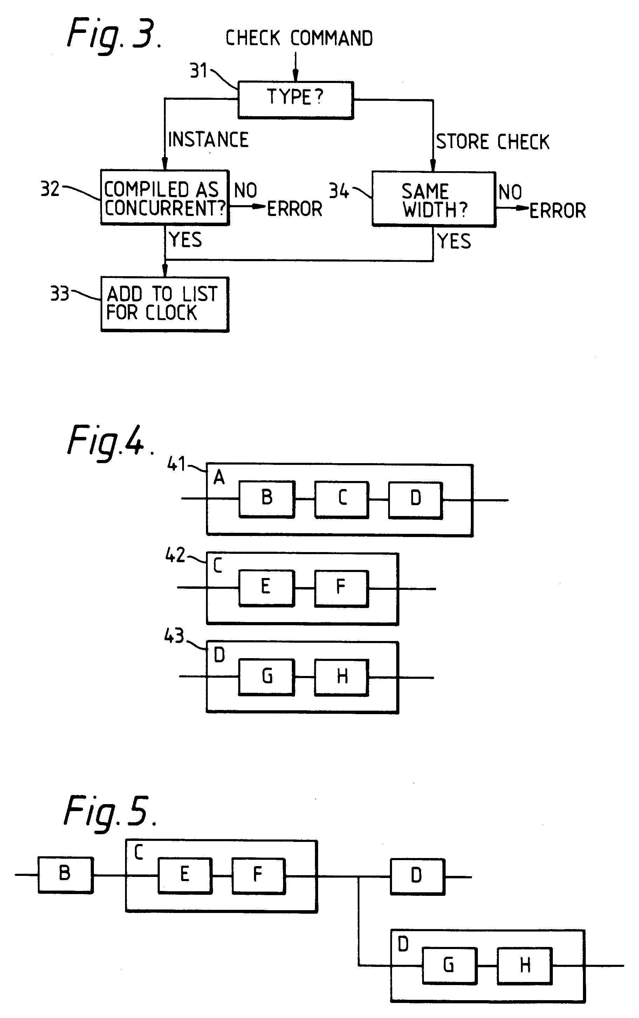

Referring to Figure 3, this shows the operation of the CHECK command. This command is normally called after completion of compilation, during the simulation run.

The CHECK command has two forms. The first form specifies a particular instance of a design unit that has been compiled in concurrent form, and specifies that the outputs from the sub-network and behavioural simulations for that instance are to be compared at a specified frequency. The second form specifies two areas of store, and specifies that these two areas are to be compared at a specified frequency. An area may be a single bit, a range of bits, a field in a data structure, or the whole of the data storage.

The comparison frequencies are specified in terms of a set of clock signals, each of which has a particular repetition frequency. Each clock has a set of checks associated with it, containing a number of comparisons that are to be made at each occurrence of that clock. Alternatively, the frequency may be specified as "immediate" or "off".
(31) The first action when the CHECK command is called is to determine the type of command (instance or store check).
(32) If an instance was specified, the command checks whether the specified instance has been compiled in concurrent form. If not, an error message is returned.
(33) Assuming that the specified instance has been compiled in concurrent form, the CHECK command then adds an entry to the set of checks associated with the clock signal for the specified frequency.
(34) If a store check has been specified, the command checks whether the specified areas of store are of the same width. If not, an error message is returned. If they are of the same width, an entry is added to the set for the appropriate clock.

It should be noted that when the CHECK command is called, the user only needs to supply the name of the instance for which comparisons are to be made, rather than specifying the names of each individual output port from that instance. The number of output ports may be very large (more than 50) and hence this can lead to considerable improvement in productivity for the user.

Another command (SUPPRESS) is also provided to enable the user to switch off checking on particular ports of an instance. This is required when aspects of the sub-network are not modelled in the behaviour - for example parity signals.

### Example of Operation

An example of the operation of the compilation mechanism will now be described with reference to Figures 4 and 5.

Figure 4 represents the contents of the design database 14. In this example, the database includes three network objects 41-43. Object 41 indicates that the design Unit A can be expanded as a sub-network, consisting of lower-level design units B, C and D. Object 42 indicates that Unit C can in turn be expanded as a sub-network consisting of units E and F, while object 43 indicates that Unit D can be expanded as a sub-network consisting of Units G and H.

It is assumed that, in this example, the steering file 18 contains the following statements:
Network, A
Behaviour, B
Network, C
Concurrent, D

In order to generate a simulation model for the top-level design unit A, a call is made to the compiler, specifying that Unit A is to be compiled.

The compiler first selects unit A for processing, and finds the corresponding statements in the steering file. Since this contains the keyword "Network", unit A is expanded as a sub-network 41.

The compiler then selects unit B for processing. Since "Behaviour" is specified for this unit, the compiler records a reference to the appropriate behavioural specification for B into the simulation model.

The compiler then selects unit C for processing. Since "Network" is specified for this unit, the compiler expands C as a sub-network 42.

The compiler then selects unit D for processing, Since "Concurrent" is specified, the compiler records a reference to the behavioural specification for D into the model and also expands D as a sub-network 43.

Figure 5 represents the simulation model after these steps have been performed. It can be seen that the model contains two concurrent representations of D, in terms of its behaviour and its network expansion. Thus, when the simulation model is run, the CHECK command can be used to compare the results of these two representations, to check that they are equivalent, without the need for any pattern extractions.

## Claims

1. A compilation mechanism for generating a simulation model of a logic system comprising a plurality of design units connected together in a network, characterised in that the compilation mechanism is selectively operable to expand a selected one of said design units as a sub-network and also concurrently to represent that design unit by means of a behavioural specification arranged in parallel with said sub-network.

2. A mechanism according to Claim 1 including CHECK command means for comparing outputs from said sub-network and said behavioural simulation, and SUPPRESS command means for inhibiting checks on particular ports of said sub-network.

3. A compilation mechanism according to Claims 1 or 2, including a design database for holding network objects defining design units in terms of sub-networks, and a behaviour library for holding behaviour specifications defining design units in terms of their behaviours.

4. A compilation mechanism according to Claim 3, further including a steering file comprising a set of statements, each specifying whether a design unit is to be expanded as a sub-network, represented in terms of its behaviour specification, or concurrently expanded as a sub-network and represented in terms of its behaviour specification.

5. A simulation model of a logic system comprising a plurality of design units connected together in a network, characterised in that at least one of said design units is expanded as a sub-network and also concurrently represented by a behavioural specification arranged in parallel with said sub-network.

6. A simulation model according to Claim 5 further including CHECK command means for comparing outputs from said sub-network and said behavioural simulation and SUPPRESS command means for inhibiting checks on particular ports of the said sub-network.

## Patentansprüche

1. Kompilierungsmechanismus zur Erzeugung eines Simulationsmodells eines logischen Systems, mit einer Mehrzahl von Konstruktionseinheiten, die in einem Netzwerk miteinander verbunden sind, dadurch gekennzeichnet, daß der Kompilierungsmechanismus selektiv so betätigbar ist, daß eine ausgewählte der Konstruktionseinheiten als Teil-Netzwerk erweitert wird, und gleichzeitig diese Konstruktionseinheit mit Hilfe einer Verhaltens-Spezifikation, die parallel zu dem Teil-Netzwerk angeordnet ist, darstellt.

2. Kompilierungsmechanismus nach Anspruch 1, gekennzeichnet durch eine CHECK (KONTROLL) - Befehlsvorrichtung zum Vergleichen von Ausgängen aus dem Teil-Netzwerk und der Verhaltens-Simulation, und eine SUPPRESS (UNTERDRÜCK) - Befehlsvorrichtung zum Sperren von Kontrollen an bestimmten Ports des Teil-Netzwerkes.

3. Kompilierungsmechanismus nach Anspruch 1 oder 2, gekennzeichnet durch eine Konstruktions-Datenbank zum Halten von Netzwerk-Objekten, die Konstruktionseinheiten in Form von Teil-Netzwerken definieren, und eine Verhaltens-Bücherei zur Aufnahme von Verhaltens-Spezifikationen, die Konstruktionseinheiten entsprechend ihrem Verhalten definieren.

4. Kompilierungsmechanismus nach Anspruch 3, gekennzeichnet durch eine Steuerungs-Datei, die einen Satz von Statements aufweist, deren jedes spezifiziert, ob eine Konstruktionseinheit als Teil-Netzwerk erweitert wird, das in Form ihrer Verhaltens-Spezifikation dargestellt wird, oder gleichzeitig als Teil-Netzwerk erweitert und als Verhaltens-Spezifikation dargestellt wird.

5. Simulationsmodell eines logischen Systems, mit einer Mehrzahl von Konstruktionseinheiten, die miteinander in einem Netzwerk verbunden sind, dadurch gekennzeichnet, daß mindestens eine der Konstruktionseinheiten als ein Teil-Netzwerk erweitert und gleichzeitig durch eine Verhaltens-Spezifikation dargestellt wird, die parallel zu dem Teil-Netzwerk angeordnet ist.

6. Simulationsmodell nach Anspruch 5, gekennzeichnet durch eine CHECK-Befehlsvorrichtung zum Vergleichen von Ausgängen aus dem Teil-Netzwerk und der Verhaltens-Simulation, und eine SUPPRESS-Befehlsvorrichtung zum Sperren von Kontrollen an bestimmten Ports des Teil-Netzwerkes.

## Revendications

1. Mécanisme de compilation pour générer un modèle de simulation d'un système logique comprenant une pluralité d'unités de conception raccordées ensembles dans un réseau, caractérisé en ce que le mécanisme de compilation est utilisable sélectivement pour étendre celle sélectionnée desdites unités de conception comme un sous-réseau et aussi concurremment pour représenter cette unité de conception au moyen d'une spécification comportementale disposée en parallèle avec ledit réseau.

2. Mécanisme selon la revendication 1 comprenant un moyen de commande CONTRÔLE pour comparer des sorties dudit sous-réseau et de ladite simulation comportementale, et un moyen de commande de SUPPRESSION pour empêcher des contrôles sur des ports particuliers dudit sous-réseau.

3. Mécanisme de compilation selon les revendications 1 ou 2, comprenant une base de données de conception pour contenir des objets de réseau définissant des unités de conception en termes de sous-réseau, et une bibliothèque de comportements pour contenir des spécifications de comportement définissant des unités de conception en termes de leurs comportements.

4. Mécanisme de compilation selon la revendication 3, comprenant en outre un fichier de pilotage comprenant un jeu de formulations, chacune spécifiant si une unité de conception est à étendre comme un sous-réseau, représentée en termes de sa spécification de comportement, ou concurremment étendue comme un sous-réseau et représentée en termes de sa spécification de comportement.

5. Modèle de simulation d'un système logique comprenant une pluralité d'unités de conception raccordées ensembles dans un réseau, caractérisé en ce qu'au moins une desdites unités de conception est étendue comme un sous-réseau et aussi concurremment représentée par une spécification comportementale disposée en parallèle avec ledit réseau.

6. Modèle de simulation selon la revendication 5 comprenant en outre un moyen de commande de CONTRÔLE pour comparer des sorties dudit sous-réseau et ladite simulation comportementale et un moyen de commande de SUPPRESSION pour empêcher des contrôles sur des ports particuliers dudit sous-réseau.
